# EUROPEAN PATENT SPECIFICATION

(11) **EP 3 567 387 B1**
(45) Date of publication and mention of the grant of the patent: **13.12.2023**
(21) Application number: 19173259.3
(22) Date of filing: 08.05.2019
(51) Int. Cl.: G01R 23/16

(54) **A SIGNAL PROCESSOR**
SIGNALPROZESSOR
PROCESSEUR DE SIGNAL

(30) Priority: 10.05.2018 GB 201807621
(43) Date of publication of application: 13.11.2019
(73) Proprietor: Thales Holdings UK Plc, Reading, Berkshire RG2 6GF (GB)
(72) Inventor: GORISSE, Benoit, Crawley, West Sussex RH10 9HA (GB); LAVIEC, Phillippe, 29238 Brest Cedex 3 (FR); ASHWORTH, Ian, Crawley, West Sussex RH10 9HA (GB)
(74) Representative: Marks & Clerk LLP

(56) References cited:
- US-A1- 2017 336 450
- US-A1- 2018 083 816
- HUANG SHAN ET AL: "Frequency estimation of multiple sinusoids with three sub-Nyquist channels", SIGNAL PROCESSING, ELSEVIER SCIENCE PUBLISHERS B.V. AMSTERDAM, NL, vol. 139, 17 April 2017 (2017-04-17), pages 96-101, XP085008642, ISSN: 0165-1684, DOI: 10.1016/J.SIGPRO.2017.04.013

## Description

### FIELD

The present disclosure relates to signal processing. It is particularly relevant to the processing of signals derived from radio frequency (RF) electromagnetic radiation.

### BACKGROUND

There are many circumstances in which it is desired to collect signal information modulated onto electromagnetic transmissions in the RF spectrum. In many environments, RF electromagnetic activity is relatively high. This impacts on the ability of electronic equipment to collect information from the RF spectrum and maintain real-time processing.

Most RF signal processing equipment has a maximum processing capability. So, if RF activity is too high, then signal processing equipment may be unable to maintain throughput, and this will lead to bottlenecks and loss of real-time performance.

One approach to resolving this is to implement sampling. Sampling takes account of the likely limit of downstream signal processing elements, and will thus limit the amount of information presented thereto. It is desirable to set sampling rates as low as possible, to reduce design constraints on downstream processing.

Any sampling of a signal risks loss of informational content. This is a well-known feature of sampling. It is desirable to maintain the possibility that a sampled signal can be used to reconstruct a version of the originally sampled signal. The Nyquist rate of a signal is defined as a lower bound on the sampling rate which produces samples sufficient to enable alias-free reconstruction of the signal.

For a band limited signal, namely a pure sinusoidal signal of frequency f, the Nyquist rate is 2f. If an input signal has components which all have frequencies at or below f, then a sample rate of 2f will produce samples which provide sufficient information to allow substantially alias-free reconstruction of the original signal. Of course, the reader will appreciate that an input frequency exactly half of the sample frequency will result in sample data expressing a DC level.

It will be understood by the reader that an alias-free reconstruction may not be a precise copy of the original signal; the reconstruction need only be lossless with respect to the original signal in a bandwidth of interest. It is desirable to provide a system which retains all frequency content in the first N Nyquist zones that cover the actual frequency range of interest.

Thus, for signals in general, sampling rates below the Nyquist rate offer no guarantee of producing signal samples from which the sampled signal can be reconstructed reliably. Sampling below the Nyquist rate is known as undersampling, or sub-Nyquist sampling.

One effect of sub-Nyquist sampling is the possibility that ambiguities will arise in the sampled information, such that the process of reconstruction will arrive at two or more possible reconstruction solutions. This is because, for a signal of frequency above half the sampling frequency, the resultant samples may be indistinguishable from samples had they been obtained from a signal of frequency within a band whose upper limit is defined by half the sampling frequency.

Reconstruction of samples in such circumstances can present a problem, in that either it must be assumed that the samples arise from signals within the Nyquist sampling band, or it must be acknowledged that the samples give rise to ambiguities which may be difficult to resolve. These ambiguities may include frequency ambiguities. That is, the frequency of the sampled signal may not be discernible from the samples. Reconstruction may therefore give rise to results whereby a reconstructed signal may be different from the original signal.

Even if signal reconstruction is not the intended objective, ambiguities in the data may be undesirable. For instance, if a system is intended to detect specific frequencies, or combinations of frequencies (such as a signal "signature"), then ambiguities in the sample stream may hamper this detection process.

Another effect of sub-Nyquist sampling is that of blindness to certain frequencies. That is, certain input frequencies give rise to no information appearing on the sample stream. In particular, sampling theory shows that sampling at a frequency will cause at least some information loss relating to signal components at frequencies which are integer multiples of half of the sampling frequency. This may be undesirable in cases whereby a detector is intended to detect such a frequency, and thus is incapable of doing so.

US 2017/336450 A1 discloses a digital receiver comprising at least two reception pathways, the method carries out a digital inter-correlation of the signals obtained as output from at least two filters of different central frequencies and different ranks, the rank and the central frequency of the filters being chosen as a function of a determined frequency-wise search domain. US 2018/083816 A1 discloses an array-based Compressed sensing Receiver Architecture (ACRA) including an antenna array with two or more antennas connected to two or more ADCs that are clocked at two or more different sampling rates below the Nyquist rate of the incident signals. Huang Shan et al. "Frequency estimation of multiple sinusoids with three sub-Nyquist channels" discloses frequency estimation of signals in the time domain through undersampled data.

### DESCRIPTION OF DRAWINGS

Figure 1 is a schematic diagram of an antenna installation in accordance with a specific embodiment; and
Figure 2 is a system diagram of a signal processor of the installation illustrated in figure 1.

### DESCRIPTION OF SPECIFIC EMBODIMENTS

According to an aspect of the invention there is provided a signal processor for processing an input signal, the processor comprising: a first antenna feed for conveying a first input signal from a first antenna; a second antenna feed for conveying a second input signal from a second antenna; a first signal sampler operable to sample the first input signal at a first sampling frequency to produce a first sample stream; a second signal sampler operable to sample the first input signal at a second sampling frequency to produce a second sample stream; a third signal sampler operable to sample the second input signal at a third sampling frequency to produce a third sample stream; a fourth signal sampler operable to sample the second input signal at a fourth sampling frequency to produce a fourth sample stream; wherein the first, second, third and fourth sampling frequencies are different from each other, and no one of the first, second, third and fourth sampling frequencies is a harmonic of another; and a signal frequency feature detector operable to detect, on the basis of information on at least three of the first, second, third and fourth sample streams, a signal frequency feature on the first and second input signals, wherein the signal frequency feature detector is operable to detect the existence, on each sample stream, of a frequency feature, and to generate an output describing the detected frequency feature and to determine a detection on the basis of detecting the existence, on three out of the four sample streams consistent with the existence of the frequency feature.

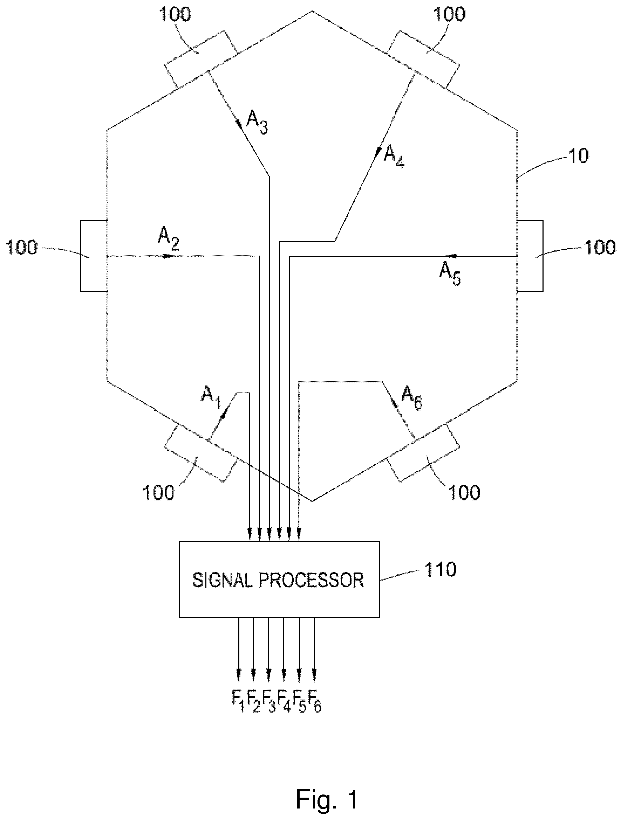

An installation in accordance with a first specific embodiment is illustrated in figure 1. The installation comprises an array of six radio frequency (RF) antennas 100 affixed to a mast 10 of a ship. For the purpose of this example, the mast 10 is of hexagonal cross-section, but the reader will appreciate that this is purely for the purpose of simplicity, and no special effect is implicit from the shape of the mast 10. Similarly, the reader will appreciate that although there are six antennas shown in figure 1, this is by way of example only, and other embodiments may include a different number of antennas.

Each antenna 100 has a receiving pattern such that it is capable of receiving from wide angles. For the purpose of this example, it is assumed that the receiving patterns of adjacent antennas 100 substantially overlap. This means that the signals picked up by adjacent antennas in the ring as depicted may have certain components in common. The signals detected at the antennas are named *Aᵢ*, where (1 ≤ *i* ≤ *N*) and, in this example, *N* = 6.

The signals *Aᵢ* received by the antennas 100 are passed, by suitable parallel wired connections, to a signal processor 110. The signal processor 110 is operable to resolve the antenna signals *Aᵢ* into digital detection signals *Fⱼ* where (1 ≤ *j* ≤ *M*) and, in this example, *M* = 6.

The reader will note that, in this example, *M* = *N* = 6. That is, there are six digital detection signals *Fⱼ*, corresponding with the six antenna signals *Aᵢ*. However, as will become clear from the following description, each digital detection signal *Fⱼ* is derived not only from a single antenna signal *Aᵢ* , but also on information received on others of the antenna signals. Thus, in other embodiments, it may be appropriate for the signal processor 110 to produce fewer, or more, digital detection signals than input antenna signals, as required.

The purpose of the signal processor 110 is to detect RF emissions incident on the antennas, and present in the antenna signals *Aᵢ*. An RF emission incident on the mast 10 will cause a corresponding component in each antenna signal. The amplitude, phase and timing of each component will depend on the physical position and orientation of each antenna. So, an antenna directly facing the source of the RF emission will cause a relatively strong component to be formed on the corresponding antenna signal, while other antenna signals, corresponding to antennas angled away from the RF emission source, will have components which are relatively weaker, later, and phase shifted. An antenna facing directly away from the RF emission may be completely blocked and the corresponding antenna signal may lack a component corresponding to the RF emission or one at a level which is practically undetectable.

So, in general terms, for any given RF emission incident on the mast 10, there will be up to *N* representations of the RF emission in the antenna signals *Aᵢ*. Each representation of the RF emission will have a different measured power, time of arrival, and phase.

By comparing the antenna signals, RF emissions can be better detected. The signal processor 110 is operable to resolve RF emissions from the collective information presented as the group of antenna signals *Aᵢ*. This is achievable at sampling frequencies which would be otherwise below theoretical minima, by way of comparison of signals acquired from two or more antennas, and by sampling antenna signals at plural distinct sampling frequencies.

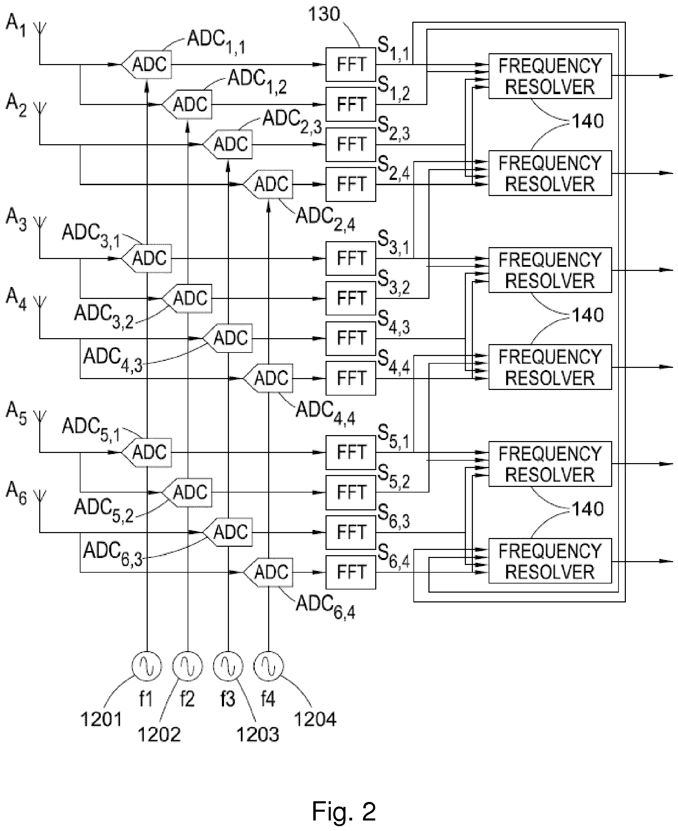

The manner in which this is achieved in this embodiment will now be described in detail with reference to figure 2. In general terms, the antenna signals *Aᵢ* are passed to a bank of analogue to digital converters (ADC) *C_{i,f}* where *i* is the antenna index previously noted, and *f* is an index to one of four sampling frequencies *f*₁, *f*₂, *f*₃, *f*₄. The selection of the sampling frequencies and their properties will be discussed in due course. Each ADC *C_{i,f}* is driven by a sampling frequency delivered by one of four frequency generators 1201, 1202, 1203 and 1204 set, respectively, to frequencies *f*₁, *f*₂, *f*₃, *f*₄.

The processing of signals will be described, in figure 2, with reference to the signals received from the first and second of the antennas, labelled *A*₁ and *A*₂ in figure 2.

*A₁* is passed to first and second ADCs *C*_{1,1} and *C*_{1,2}. Likewise, *A*₂ is passed to ADCs *C*_{2,3} and *C*_{2,4}.

Similarly, signals from the other antennas, namely *A*₃, *A*₄, *A*₅ and *A*₆ are each passed to two ADCs of the bank of ADCs. So,:
- *A*₃ is passed to ADCs *C*_{3,1} and *C*_{3,2};
- *A*₄ is passed to ADCs *C*_{4,3} and *C*_{4,4};
- *A*₅ is passed to ADCs *C*_{5,1} and *C*_{5,2}; and
- *A*₆ is passed to ADCs *C*_{6,3} and *C*_{6,4}.

Digital signals from the ADCs *C_{i,f}* are passed to respective Fast Fourier Transform (FFT) units 130. The FFT units 130 output respective frequency domain detection signals *S_{i,f},* indexed as for their corresponding ADCs. Each frequency domain detection signal consists of spectral peaks describing the instances of frequencies, during the sampling period employed by the FFT in question.

As the outputs of the FFT units 130 are to be used in combination, it is desirable that all of the FFT units have the same frame time. That is, the relationship between the length of the FFT used (in terms of the number of samples) and the sample frequency of the corresponding FFT, is fixed for each channel. This will be recognised by the reader as a way of achieving synchronisation between channels, but the reader will also recognise that other approaches could be take, such as zero padding.

The FFT units act as frequency detectors. The reader will appreciate that the function of a frequency detector could be provided by other means.

The frequency domain detection signals *S_{i,f}* are then passed to a bank of frequency resolvers 140. Each frequency resolver 140 is in receipt of four frequency domain detection signals *S_{i,f}* from FFT units 130.

The stream of frequency domain detection signals *S_{i,f}* from each FFT unit to its frequency resolver can be any number between 1 and U2, where L is the FFT length in samples. In implementations of the embodiment, it is common to take L between 1 and 30. A reasonable practical limit for an implementation of the present embodiment is that L=24.

Each frequency resolver receives two frequency domain detection signals *S_{i,f},* from each of two adjacent antennas, so:
- the first frequency resolver 140 receives *S*_{1,1}, *S*_{1,2}, *S*_{2,3} and *S*_{2,4}, from respective FFT units;
- the second frequency resolver 140 receives *S*_{2,3}, *S*_{2,4}, *S*_{3,1}, and *S*_{3,2};
- the third frequency resolver 140 receives *S*_{3,1}, *S*_{3,2}, *S*_{4,3} and *S*_{4,4};
- the fourth frequency resolver 140 receives *S*_{4,3}, *S*_{4,4}, *S*_{5,1} and *S*_{5,2},;
- the fifth frequency resolver 140 receives *S*_{5,1}, *S*_{5,2}, *S*_{6,3} and *S*_{6,4}; and
- the sixth frequency resolver 140 receives *S*_{6,3}, *S*_{6,4}, *S*_{1,1} and *S*_{1,2}.

Each frequency domain detection signal *S_{i,f}* therefore corresponds to a given RF emission detected, and there may be up to Q RF emissions. That is, a total of *D* _{*} *Q* frequency domain detection signals may be generated, where *D* is the number of detectable RF emissions.

As will be appreciated, this means that each frequency resolver applies two dimensions of anti-aliasing. Each frequency resolver receives two pieces of information from two antennas. That is, for both antennas for which each frequency resolver receives information, the antenna signal is expressed in terms of two different sampling frequencies. So, if a sampling hole arises in respect of one spectral signal, that is, for a particular antenna at a particular sampling frequency, that spectral hole has a prospect of being resolved by reference not only to that antenna at a different sampling frequency, but also to another antenna sampled at two yet further sampling frequencies.

Each frequency resolver combines the information received on the four received digital signals. It does this by way of a frequency resolution algorithm. Any suitable frequency resolution algorithm will achieve appropriate results, and the present disclosure is not limited to any one particular approach. However, for the purpose of guidance, the reader is directed to the algorithm disclosed in UK Patent Application 2401269. In summary, that approach involves an additive approach, so that the sequence of frequency information received from the four FFTs input to any particular frequency resolver reinforce each other. This means that frequency information not gleaned from one FFT will be acquired from at least one other.

In particular, for any given frequency resolver 140, it is in receipt periodically of a set of four digitised spectra, from its respective four associated FFTs. The spectra are derived from sample time-domain input samples taken from sampling windows applied to the signals received on the antennas. The length of the sampling window is defined by the FFTs, and is dependent on the four sampling frequencies *f*₁ to *f*₄.

For ease of description, in respect of frequency resolver with index *i*, the four sources of spectrum events are *S_{i,a}*, *S*_{*i,a*+1}, *S*_{|*i*+1|_{N},*b*} and S_{|*i*+1|_{N},*b*+1} where a is either 1 or 3 and b is either 3 or 1, as the case may be, and *N* is the number of antennas. *S_{i,a}, S*_{*i,a*+1} are referred to herein as the primary pair, and S_{|*i*+1|_{N},*b*}, *S*_{|*i*+1|_{N},*b*+1} as the secondary pair.

So, for each spectrum detection appearing at an input of the frequency resolver 140, the frequency resolver checks the other inputs. If the same event appears at all of the other inputs, no aliasing has arisen and the RF signal originating the spectral peak has been correctly identified. In that case, the frequency resolver simply outputs information describing the RF signal as an identified signal without ambiguity. This is because, in these cases, no ambiguity exists, and it can be reasonably assumed that the frequency described by each of *S_{i,a}, S*_{*i,a*+1}*, S*_{|*i*+1|_{N},b} and S_{|*i*+1|_{N},*b*+1} is the correct frequency of the originally detected RF emission.

If a spectral peak arises at one input and the check at other inputs finds that the same spectral peak does not arise at one or more of the other inputs, an ambiguity has arisen. The ambiguities arise as a result of the under-sampling of the RF signal, which in turn results in frequencies above the Nyquist frequency being folded down to lower frequencies within the Nyquist band. In other words, there is ambiguity concerning whether a spectral peak appearing at a particular frequency in one of the input signals to the frequency resolver 140 reflects the genuine presence of a signal at that frequency, or whether the spectral peak in question reflects the presence of a higher frequency signal that has been under-sampled and which consequently is folded down to a lower frequency in the Nyquist band. The frequency resolver has to take these two different possibilities into account, in order to resolve this ambiguity in the signal.

The spectral peak under consideration is processed by the frequency resolver, to generate a list of candidate frequencies that the spectral peak may actually represent. The number of candidates is not material to this disclosure, but, for example, a list of 2 candidate frequencies may be generated, per input to the frequency resolver 140.

The generated candidate frequencies for the first input are then compared with respective candidate frequencies for the other three inputs to the frequency resolver 140, to find matches. If one of the candidate frequencies is present in the list of candidate frequencies associated with at least two of the other three inputs, then the frequency resolver 140 concludes that that candidate frequency is the correct frequency incorrectly expressed (undersampled) on the original sample stream. In that event, the original frequency peak in the original sample stream is discarded, and replaced by the identified disambiguating match.

Using four spectra in this way takes account of the fact that a sampler will be blind (i.e. does not provide reliable amplitude and phase information) at frequencies around a multiple of half the sampling frequency.

It will be appreciated that the same RF emission may have been detected at multiple antennas, indeed possibly at all antennas. In that case, several (or all) of the frequency resolvers may detect the same RF emission. So, for example, a data processor can be placed after the bank of frequency resolvers, to collate all the information generated thereby and to deduplicate the information.

The four sampling frequencies are, in this example, selected with a view to balancing the measurement accuracy of the system. By selecting four sampling frequencies which are different, the risk of more than one of the samplers being blind to an input response will be reduced.

For practical reasons, it may be convenient to derive all four frequencies from a common base frequency. This enables the possibility of generating all four sampling frequencies by a single signal generator. In one example, all four frequencies are harmonics of 28MHz.

In this embodiment, sampling frequencies are reused so that each resolver receives four FFT data streams. For each resolver, the four input data streams are derived respectively from the same set of four sampling frequencies. That means that each resolver is in effect the same in terms of construction and configuration. This provides a potential advantage in that the hardware (and, in some embodiments, software) used to implement a frequency resolver may be re-used so as to implement up to all six of the resolvers on a single device. This may have implications for power consumption, size and efficiency. Moreover, if the information disambiguation function of the bank of frequency resolvers is implemented in software, the fact that each combination of four inputs is derived from the same set of sample frequencies may result in processing efficiencies. The possibility exists for sequential processing of different combinations of inputs by a single frequency resolver device or software routine.

However, the reader will appreciate that this is not essential, and different combinations of antenna signals might be sampled at different frequencies. For instance, it may be known that, for a particular mast orientation, certain signals of interest are likely to be incident on one side of the mast and not on the other. In such circumstances, it may be desirable to process different pairs of antenna signals differently.

Whereas the specific embodiments described herein present an apparatus comprising six antennas, the reader will appreciate that the underlying technical principles can be applied to other arrangements. For instance, any number of antennas, from two antennas and above, could be employed, with appropriate adjustments and/or modifications to the ADC, FFT and frequency resolved elements described with respect to the embodiments described above.

The example described herein involves digitisation of the sampled signals. However, another approach, in accordance with the present disclosure, could involve an analogue detection chain, such as a video detector. In such a case, it would be recognised by the reader that analogue signal processing invokes certain technical limitations, in certain cases, as compared with digital signal processing, such as that it may only be possible to detect a single signal frequency at any one time.

The embodiments described herein employ FFT as a time-frequency transform. However, the reader will recognise that this is only one of many types of transform between time and spectrum domains. So, any frequency detector would suffice. While certain embodiments have been described, these embodiments have been presented by way of example only, and are not intended to limit the scope of the inventions.

## Claims

1. A signal processor (110) for processing an input signal, the processor comprising:
a first antenna feed for conveying a first input signal from a first antenna (100);
a second antenna feed for conveying a second input signal from a second antenna (100);
a first signal sampler operable to sample the first input signal at a first sampling frequency to produce a first sample stream;
a second signal sampler operable to sample the first input signal at a second sampling frequency to produce a second sample stream;
a third signal sampler operable to sample the second input signal at a third sampling frequency to produce a third sample stream;
a fourth signal sampler operable to sample the second input signal at a
fourth sampling frequency to produce a fourth sample stream;
wherein the first, second, third and fourth sampling frequencies are different from each other, and no one of the first, second, third and fourth sampling frequencies is a harmonic of another; and
a signal frequency feature detector operable to detect, on the basis of information on at least three of the first, second, third and fourth sample streams, a signal frequency feature on the first and second input signals, wherein the signal frequency feature detector is operable to detect the existence, on each sample stream, of a frequency feature, and to generate an output describing the detected frequency feature and to determine a detection on the basis of detecting the existence, on three out of the four sample streams consistent with the existence of the frequency feature.

2. A signal processor (110) in accordance with claim 1 wherein the first, second, third and fourth samplers each comprise a digitiser operable to convert a sampled instantaneous signal value into a digital representation thereof, the digitisers being operable to present the digital representations of the signal values to the respective sample streams.

3. A signal processor (110) in accordance with claim 2 wherein each digitiser comprises an analogue to digital converter, ADC, operable to convert said sampled instantaneous signal values to said digital representations.

4. A signal processor (110) in accordance with claim 1 wherein the first, second, third and fourth samplers each comprise a respective signal domain transformer operable to transform signal values generated by the samplers into a frequency response, the signal domain transformers being operable to present the frequency responses to the respective sample streams.

5. A signal processor (110) in accordance with claim 4 wherein each signal domain transformer is operable to apply a Fourier-type transform on signal values.

6. A signal processor (110) in accordance with claim 5 wherein each signal domain transformer is operable to apply a Fast Fourier Transform, FFT, on signal values.

7. A signal processor (110) in accordance with any preceding claim wherein, in response to detection of frequency features on a plurality of the sample streams, the signal processor (110) is operable to determine if a first of said detected frequency features corresponds with others of said plurality of frequency features, by reference to a frequency component candidate detected in the first frequency feature and comparison thereof with frequency component candidates, and harmonics thereof, of said others of said plurality of frequency features, and to make a determination of a component frequency of the frequency feature on the basis of information from a majority of the sample streams.

8. A signal processor (110) in accordance with any preceding claim wherein the signal frequency feature on the first and second input signals is a radio frequency excitation on the first and second input signals.

9. A detection apparatus comprising a signal processor (110) in accordance with claim 1 and a multi-antenna cluster, the multi-antenna cluster comprising a plurality of antennas (100), and wherein each signal processing element is configured to receive feeds from two antennas (100) sufficiently adjacent to each other that signals in use detected thereby are capable of exceeding detection thresholds of at least three of the four samplers of the signal processing element.

10. A detection apparatus in accordance with claim 9 wherein the antennas (100) are arranged in a ring.

11. A detection apparatus in accordance with claim 10 wherein each signal processing element is configured to receive feeds from two adjacent antennas (100) in the ring.

## Patentansprüche

1. Signalprozessor (110) zum Verarbeiten eines Eingangssignals, wobei der Prozessor umfasst:
eine erste Antennenspeisung zum Übertragen eines ersten Eingangssignals von einer ersten Antenne (100);
eine zweite Antennenspeisung zum Übertragen eines zweiten Eingangssignals von einer zweiten Antenne (100);
einen ersten Signalabtaster, der so betrieben werden kann, dass er das erste Eingangssignal mit einer ersten Abtastfrequenz abtastet, um einen ersten Abtaststrom zu erzeugen;
einen zweiten Signalabtaster, der so betrieben werden kann, dass er das erste Eingangssignal mit einer zweiten Abtastfrequenz abtastet, um einen zweiten Abtaststrom zu erzeugen;
einen dritten Signalabtaster, der so betrieben werden kann, dass er das zweite Eingangssignal mit einer dritten Abtastfrequenz abtastet, um einen dritten Abtaststrom zu erzeugen;
einen vierten Signalabtaster, der so betrieben werden kann, dass er das zweite Eingangssignal mit einer vierten Abtastfrequenz abtastet, um einen vierten Abtaststrom zu erzeugen;
wobei die erste, zweite, dritte und vierte Abtastfrequenz voneinander verschieden sind und keine der ersten, zweiten, dritten und vierten Abtastfrequenzen eine Harmonische einer anderen ist, und
einen Signalfrequenzmerkmalsdetektor, der betreibbar ist, um auf der Grundlage von Informationen über mindestens drei der ersten, zweiten, dritten und vierten Abtastströme ein Signalfrequenzmerkmal auf den ersten und zweiten Eingangssignalen zu detektieren, wobei der Signalfrequenzmerkmaldetektor betreibbar ist, um das Vorhandensein eines Frequenzmerkmals auf jedem Abtaststrom zu detektieren und um eine Ausgabe zu erzeugen, die das detektierte Frequenzmerkmal beschreibt, und um eine Detektion auf der Grundlage des Detektierens des Vorhandenseins auf drei der vier Abtastströme zu bestimmen, die mit dem Vorhandensein des Frequenzmerkmals übereinstimmt.

2. Signalprozessor (110) nach Anspruch 1, wobei der erste, zweite, dritte und vierte Abtaster jeweils einen Digitalisierer umfassen, der so betrieben werden kann, dass er einen abgetasteten momentanen Signalwert in eine digitale Darstellung desselben umwandelt, wobei die Digitalisierer so betrieben werden können, dass sie die digitalen Darstellungen der Signalwerte an die jeweiligen Abtastströme weitergeben.

3. Signalprozessor (110) nach Anspruch 2, wobei jeder Digitalisierer einen Analog-Digital-Wandler (ADC) umfasst, der betreibbar ist, um die abgetasteten momentanen Signalwerte in die digitalen Darstellungen umzuwandeln.

4. Signalprozessor (110) nach Anspruch 1, wobei der erste, der zweite, der dritte und der vierte Abtaster jeweils einen entsprechenden Signalbereichstransformator umfassen, der betreibbar ist, um die von den Abtastern erzeugten Signalwerte in eine Frequenzantwort umzuwandeln, wobei die Signalbereichstransformatoren so betreibbar sind, dass sie den jeweiligen Abtastströmen die Frequenzantworten vorlegen.

5. Signalprozessor (110) nach Anspruch 4, wobei jeder Signalbereichstransformator so betreibbar ist, dass er eine Fourier-Transformation auf Signalwerte anwendet.

6. Signalprozessor (110) nach Anspruch 5, wobei jeder Signalbereichstransformator so betrieben werden kann, dass er eine Fast-Fourier-Transformation, FFT, auf die Signalwerte anwendet.

7. Signalprozessor (110) nach einem der vorhergehenden Ansprüche, wobei der Signalprozessor (110) als Reaktion auf die Detektion von Frequenzmerkmalen in einer Vielzahl von Abtastströmen so betreibbar ist, dass er bestimmt, ob ein erstes der erkannten Frequenzmerkmale mit anderen der Vielzahl von Frequenzmerkmalen übereinstimmt, und zwar durch Bezugnahme auf einen Frequenzkomponentenkandidaten, der in dem ersten Frequenzmerkmal erkannt wurde, und durch Vergleich desselben mit Frequenzkomponentenkandidaten und deren Harmonischen der anderen der Vielzahl von Frequenzmerkmalen, und dass er eine Komponentenfrequenz des Frequenzmerkmals auf der Grundlage von Informationen aus einer Mehrheit der Abtastströme bestimmt.

8. Signalprozessor (110) nach einem der vorhergehenden Ansprüche, wobei das Signalfrequenzmerkmal auf den ersten und zweiten Eingangssignalen eine Hochfrequenzanregung auf den ersten und zweiten Eingangssignalen ist.

9. Detektionsvorrichtung, umfassend einen Signalprozessor (110) nach Anspruch 1 und einen Mehrantennencluster, wobei der Mehrantennencluster eine Vielzahl von Antennen (100) umfasst, und wobei jedes Signalverarbeitungselement so konfiguriert ist, dass es Einspeisungen von zwei Antennen (100) empfängt, die ausreichend benachbart sind, dass damit detektierte im Betrieb Signale in der Lage sind, die Erfassungsschwellen von mindestens drei der vier Abtaster des Signalverarbeitungselements zu überschreiten.

10. Detektionsvorrichtung nach Anspruch 9, wobei die Antennen (100) in einem Ring angeordnet sind.

11. Detektionsgerät nach Anspruch 10, wobei jedes Signalverarbeitungselement konfiguriert ist, um Einspeisungen von zwei benachbarten Antennen (100) in dem Ring zu empfangen.

## Revendications

1. Processeur de signaux (110) permettant de traiter un signal d'entrée, le processeur comprenant :
une première alimentation d'antenne pour acheminer un premier signal d'entrée provenant d'une première antenne (100) ;
une deuxième alimentation d'antenne pour acheminer un deuxième signal d'entrée provenant d'une deuxième antenne (100) ;
un premier échantillonneur de signaux exploitable pour échantillonner le premier signal d'entrée à une première fréquence d'échantillonnage pour produire un premier flux d'échantillons ;
un deuxième échantillonneur de signaux exploitable pour échantillonner le premier signal d'entrée à une deuxième fréquence d'échantillonnage pour produire un deuxième flux d'échantillons ;
un troisième échantillonneur de signaux exploitable pour échantillonner le deuxième signal d'entrée à une troisième fréquence d'échantillonnage pour produire un troisième flux d'échantillons ;
un quatrième échantillonneur de signaux exploitable pour échantillonner le deuxième signal d'entrée à une quatrième fréquence d'échantillonnage pour produire un quatrième flux d'échantillons ;
dans lequel les première, deuxième, troisième et quatrième fréquences d'échantillonnage sont différentes les unes des autres et aucune des première, deuxième, troisième et quatrième fréquences d'échantillonnage n'est une harmonique d'une autre ; et
un détecteur de caractéristiques de fréquence de signal exploitable pour détecter, sur la base d'informations concernant au moins trois des premier, deuxième, troisième et quatrième flux d'échantillons, une caractéristique de fréquence de signal sur les premier et deuxième signaux d'entrée, dans lequel le détecteur de caractéristiques de fréquence de signal est exploitable pour détecter l'existence, sur chaque flux d'échantillons, d'une caractéristique de fréquence, et pour générer une sortie décrivant la caractéristique de fréquence détectée et pour déterminer une détection sur la base de la détection de l'existence, sur trois des quatre flux d'échantillons, cohérente avec l'existence de la caractéristique de fréquence.

2. Processeur de signaux (110) selon la revendication 1, dans lequel les premier, deuxième, troisième et quatrième échantillonneurs comprennent chacun un numériseur exploitable pour convertir une valeur de signal instantanée échantillonnée en une représentation numérique de celle-ci, les numériseurs étant exploitables pour présenter les représentations numériques des valeurs de signaux aux flux d'échantillons respectifs.

3. Processeur de signaux (110) selon la revendication 2, dans lequel chaque numériseur comprend un convertisseur analogique-numérique (ADC) exploitable pour convertir lesdites valeurs de signaux instantanées échantillonnées en représentations numériques.

4. Processeur de signaux (110) selon la revendication 1, dans lequel les premier, deuxième, troisième et quatrième échantillonneurs comprennent chacun un transformateur de domaine de signal respectif exploitable pour transformer les valeurs de signaux générées par les échantillonneurs en une réponse de fréquence, les transformateurs de domaine de signal étant exploitables pour présenter les réponses de fréquence aux flux d'échantillons respectifs.

5. Processeur de signaux (110) selon la revendication 4, dans lequel chaque transformateur de domaine de signal est exploitable pour appliquer une transformation de Fourier aux valeurs de signaux.

6. Processeur de signaux (110) selon la revendication 5, dans lequel chaque transformateur de domaine de signal est exploitable pour appliquer une transformée de Fourier rapide (FFT) aux valeurs de signaux.

7. Processeur de signaux (110) selon l'une quelconque des revendications précédentes, dans lequel, en réponse à la détection de caractéristiques de fréquence sur une pluralité de flux d'échantillons, le processeur de signaux (110) est exploitable pour déterminer si une première desdites caractéristiques de fréquence détectées correspond à d'autres caractéristiques de fréquence de ladite pluralité de caractéristiques de fréquence, par référence à une candidate de composantes de fréquence détectée dans la première caractéristique de fréquence et par comparaison de celle-ci avec les candidates de composantes de fréquence et leurs harmoniques desdites autres de ladite pluralité de caractéristiques de fréquence, et pour déterminer une fréquence de composantes de la caractéristique de fréquence sur la base d'informations provenant d'une majorité des flux d'échantillons.

8. Processeur de signaux (110) selon l'une quelconque des revendications précédentes, dans lequel la caractéristique de fréquence du signal sur les premier et deuxième signaux d'entrée est une excitation de radiofréquence sur les premier et deuxième signaux d'entrée.

9. Appareil de détection comprenant un processeur de signaux (110) selon la revendication 1 et un groupe d'antennes multiples, le groupe d'antennes multiples comprenant une pluralité d'antennes (100), et dans lequel chaque élément de traitement de signal est configuré pour recevoir des alimentations de deux antennes (100) suffisamment adjacentes l'une à l'autre pour que des signaux en cours d'utilisation détectés par celles-ci soient capables de dépasser les seuils de détection d'au moins trois des quatre échantillonneurs de l'élément de traitement de signal.

10. Appareil de détection selon la revendication 9, dans lequel les antennes (100) sont disposées en un anneau.

11. Appareil de détection selon la revendication 10, dans lequel chaque élément de traitement de signal est configuré pour recevoir des alimentations de deux antennes (100) adjacentes dans l'anneau.
